Europäisches Patentamt

European Patent Office

Office européen des brevets

(11) Publication number: **0 301 585**
**A2**

# EUROPEAN PATENT APPLICATION

(21) Application number: 88112357.4

(51) Int. Cl.⁴: **G03G 8/00**

(22) Date of filing: 29.07.88

(30) Priority: 30.07.87 JP 192132/87
25.08.87 JP 210893/87
23.10.87 JP 268797/87
18.12.87 JP 321990/87
18.12.87 JP 321991/87

(43) Date of publication of application:
**01.02.89 Bulletin 89/05**

(84) Designated Contracting States:
**DE FR GB**

(71) Applicant: **SHARP KABUSHIKI KAISHA**
**22-22 Nagaike-cho Abeno-ku**
**Osaka 545(JP)**

(72) Inventor: **Nagata, Shoichi**
**Yamato Ryo 492, Minosho-cho**
**Yamatokoriyama-shi Nara-ken(JP)**
Inventor: **Ohashi, Kunio**
**16-6, Sujyaku 5-chome**
**Nara-shi Nara-ken(JP)**

(74) Representative: **Patentanwälte TER MEER -**
**MÜLLER - STEINMEISTER**
**Mauerkircherstrasse 45**
**D-8000 München 80(DE)**

(54) Method of producing a glossy image and device for effecting said method.

(57) With the use of an image glazing sheet having a smooth surface and being superior in resistance to heat and mold-releasing characteristic, a glossy image can be obtained in the following manner:
mating the image glazing sheet for putting a gloss to an image to be formed with an image receiving material on which the image is formed by toner containing thermoplastic resin or which is coated with the thermoplastic resin;
applying heat and pressure to the image receiving material and the image glazing sheet;
cooling the image receiving material and the image glazing sheet: and
separating the image receiving material from the image glazing sheet.

Fig. 3

# METHOD FOR PRODUCING A GLOSSY IMAGE AND DEVICE FOR EFFECTING SAID METHOD

## BACKGROUND OF THE INVENTION

### Field of the Invention

The present invention relates to a method of putting a gloss to an image formed, with the use of toner or photo-setting microcapsules containing therein dye, on an image receiving material, for example, a paper sheet. The present invention also relates to a device for effecting this method.

### Description of the Prior Art

An image or images can be formed on a paper sheet by making use of an electrophotographic method employed in a copying apparatus, a method of utilizing an image forming material of the photosensitive and pressure-sensitive type disclosed in the USP No. 4,399,209, or the like.

In the method of the former of utilizing the electrophotographic method, after a photosensitive member has been uniformly charged, image forming light, for example, reflected light from an original document is applied to the photosensitive member to form an electrostatic latent image thereon. Toner is then caused to adhere to the electrostatic latent image to form a toner image, which is subsequently transferred onto a paper sheet used as an image receiving material. The toner image transferred onto the paper sheet is then heated by a known heating method, which will be described hereinafter, so that thermoplastic resin contained in the toner may be softened or fused to be fixed on the paper.

In the method of the latter, the image forming material of the photosensitive and pressure-sensitive type comprises a photosensitive sheet coated with a large number of microcapsules and an image receiving sheet coated with developing material. Each of the microcapsules has a diameter of 5-6 $\mu$m and contains therein photo-setting material and colorless dye, which is colored by the action of the developing material coated on the image receiving sheet. When the image forming light such as the reflected light from an original document is applied to the photosensitive sheet, only the microcapsules exposed to the light are hardened by virtue of the photo-setting material contained therein to form a hardened image. Subsequently, when the photosensitive sheet and the image receiving sheet are overlapped one over the other and subjected to pressure, unhardened microcapsules are crushed so that the colorless dye or the like may flows out therefrom. In this event, the colorless dye is colored by the developing material of the image receiving sheet to form a colored image. The Japanese Patent Laid-Open Application No. 61-24495 discloses such a coloring reaction. As disclosed in the USP No. 4,554,235, if the image receiving sheet has been coated with the thermoplastic resin in advance, heating the colored image puts a gloss thereto, since the thermoplastic resin is softened or fused.

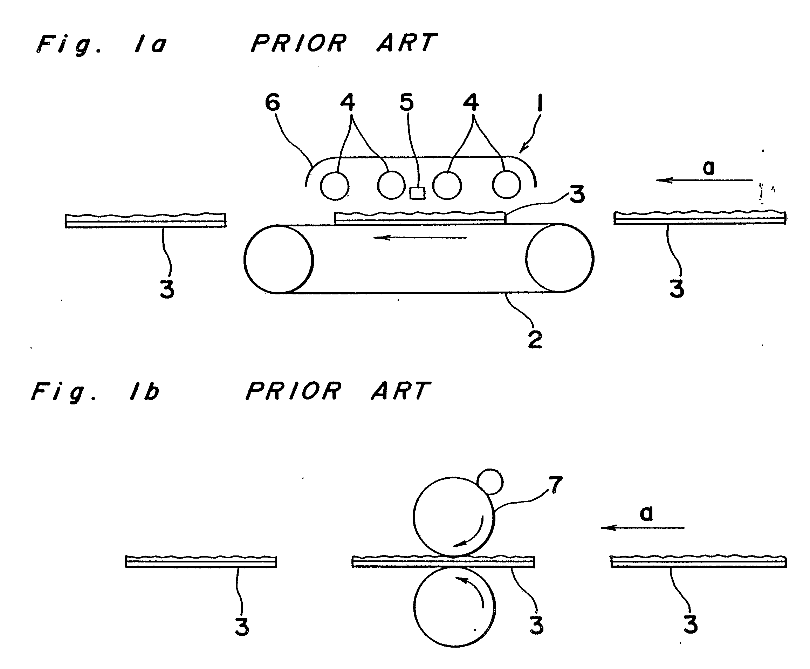

Conventionally, an indirect heating method as shown in Fig. 1a, a direct heating method as shown in Fig. 1b or the like is employed in each of the above described image forming methods. The heating is performed by means of an oven 1 in the method of Fig. 1a and by means of a heat roller 7 kept at a predetermined temperature in the method of Fig. 1b. In these figures, a reference numeral 3 represents a transfer sheet onto which a toner image has been transferred or an image receiving sheet on which a colored image has been formed, with the sheet employed as an image receiving material.

In the method of Fig. 1a, an image receiving sheet 3 having thereon an image is initially supplied towards a transport belt 2. Above the transport belt 2 is provided a heating device comprised of a plurality of heater lamps, for example, halogen lamps 4, a temperature sensor 5 and a reflector 6. The temperature sensor 5 detects temperature of the image receiving sheet 3. The reflector 6 prevents heat generated by the heater lamps 4 from radiating outside to amplify the heat to be applied to the image receiving sheet 3.

However, since the above described method of Fig. 1a employing therein the oven 1 as an indirect heating means can not smooth toner or the like adhering to the image receiving material 3, not only gloss of the material 3 is relatively low, but the device is formed disadvantageously into a large size due to low efficiency of the heating means. Furthermore, when the oven 1 is provided with exposed halogen lamps 4 as a heating source, the image receiving material 3 is occasionally brought into contact with any of the halogen lamps 4, rendering the image receiving material 3 to be scorched or burnt.

The method of Fig. 1b employing therein the heat roller 7 as the direct heating means can form a relatively smooth and glossy image, since the image receiving material 3 is subjected to heat and pressure, simultaneously. In this method, however, the softened or fused thermoplastic resin caused by the heating sometimes adheres to the heat roller 7 and produces undesirably an offset. Moreover, when an image is formed by toner comprised of resin and a coloring agent, particularly when a colored image is formed by such toner, a higher gloss thereof tends to be desired for presenting an appearance of higher grade. For this purpose, the heat roller 7 is required to be raised in temperature. However, when the temperature of the heat roller 7 is raised, the offset is liable to take place. It is, therefore, difficult to obtain the image having the high gloss without any occurrence of the offset. In addition, since the toner adhering to the heat roller 7 causes subsequent image or images to be stained, a cleaner is necessarily required for removing such toner from the heat roller 7.

Furthermore, when a photograph, an illustration or the like is copied, a high glossiness is also desired for presenting an appearance of high quality or high grade. To the contrary, when characters, business graphics, a cloth or the like is copied, any glossiness is not generally required. These requirements have not been satisfied simultaneously up to this time.

## SUMMARY OF THE INVENTION

Accordingly, the present invention has been developed with a view to substantially eliminating the above described disadvantages, and has for its essential object to provide an improved image glazing method capable of producing a glossy image without being subjected to any offset.

Another important object of the present invention is to provide an image glazing device for effecting the above described method.

A further object of the present invention is to provide an image glazing device with a glossiness regulatable function capable of changing the glossiness of an image to be formed.

In accomplishing these and other objects, a method of producing a glossy image according to one preferred embodiment of the present invention is characterized by the following steps:

mating an image glazing sheet for putting a gloss to an image to be formed with an image receiving material on which the image is formed by toner containing thermoplastic resin or which is coated with the thermoplastic resin;

applying heat and pressure to the image receiving material and the image glazing sheet;

cooling the image receiving material and the image glazing sheet; and

separating the image receiving material from the image glazing sheet.

In this method, the image glazing sheet has a smooth surface and is superior in resistance to heat and mold-releasing characteristic.

When the image receiving material mated with the image glazing sheet is subjected to both heat and pressure, the thermoplastic resin is softened or fused to become glossy. In this event, the image glazing sheet having the smooth surface smooths the surface of the thermoplastic resin to raise its glossiness. However, the image glazing sheet never be softened or fused due to its superior resistance to heat. The image receiving material is then cooled together with the image glazing sheet and readily separated therefrom, since the thermoplastic resin of the image receiving material is in a hardened state. Furthermore, the superior mold-releasing characteristic of the image glazing sheet can prevent the thermoplastic resin from adhering to the image glazing sheet.

In another aspect of the present invention, there is provided an image glazing device for putting a gloss to an image formed on an image receiving material, with the image being formed by toner containing thermoplastic resin or coated with the thermoplastic resin. The image glazing device is provided with at least two rollers disposed in a direction of feed of the image receiving material, an image glazing sheet passed between the two rollers for putting the gloss to the image formed on the image receiving material, a back-up roller disposed upstream of one of the two rollers in a direction of feed of the image receiving material for applying pressure to the image receiving material, and a heat source disposed in the vicinity of the back-up roller for heating the image receiving material. The roller located downstream of the back-up roller constitutes a separating portion for separating the image receiving material from the image glazing sheet.

By the above described construction of the image glazing device, the image receiving material is overlapped onto the image glazing sheet and subjected to both heat and pressure so that the gloss may be applied to the image formed on the image receiving material.

In the image glazing device of the present invention, the image receiving material having thereon a toner image or a colored image is overlapped onto the image glazing sheet. In this event, the image receiving material is subjected to pressure by the action of the back-up roller and heated by the image glazing sheet which has already been heated up to a desired temperature by the heat source. The application of heat and pressure fixes and smooths the toner image, if the image formed on the image receiving material is the toner image, or activates the coloring reaction and smooths the thermoplastic resin, if the image is the colored image. In this way, the thermoplastic resin is smoothed so that the gloss may be applied to the image. Upon transportation of the image receiving material by the image glazing sheet, the former is gradually cooled down and separated from the latter at a location where the roller constituting the separating portion is provided.

## BRIEF DESCRIPTION OF THE DRAWINGS

These and other objects and features of the present invention will become more apparent from the following description taken in conjunction with the preferred embodiment thereof with reference to the accompanying drawings, throughout which like parts are designated by like reference numerals, and in which:

Fig. 1a is a schematic view of a conventional heating device provided with an indirect heating means;

Fig. 1b is a schematic view of another conventional heating device provided with a direct heating means;

Fig. 2 is a schematic sectional view of an image forming apparatus accommodating an image glazing device of the present invention;

Fig. 3 is a schematic view of the image glazing device according to the first embodiment of the present invention;

Fig. 4 is a view similar to Fig. 3, according to the second embodiment of the present invention;

Fig. 5 is a block diagram of a control portion of the image forming apparatus accommodating the image glazing device with a glossiness regulatable function;

Fig. 6 is a graph indicative of the relationship between glossiness of the image and setting temperature of an image glazing sheet provided in the image glazing device;

Fig. 7 is a block diagram similar to Fig. 5, which particularly shows a modification thereof;

Fig. 8 is a view similar to Fig. 3, according to the third embodiment of the present invention;

Fig. 9 is a block diagram similar to Fig. 5, of the image forming apparatus accommodating the image glazing device of Fig. 8;

Fig. 10 is a flow-chart indicative of the operation of a part of the control portion of Fig. 9;

Fig. 11 is a view similar to Fig. 3, according to the fourth embodiment of the present invention;

Fig. 12 is a diagram similar to Fig. 9, of the image forming apparatus accommodating the image glazing device of Fig. 11;

Fig. 13 is a view similar to Fig. 3, according to the fifth embodiment of the present invention;

Fig. 14a is a view similar to Fig. 3, which particularly shows a modification thereof; and

Fig. 14b is a perspective view of the image glazing device of Fig. 14a.

## DETAILED DESCRIPTION OF THE PREFERRED EMBODIMENT

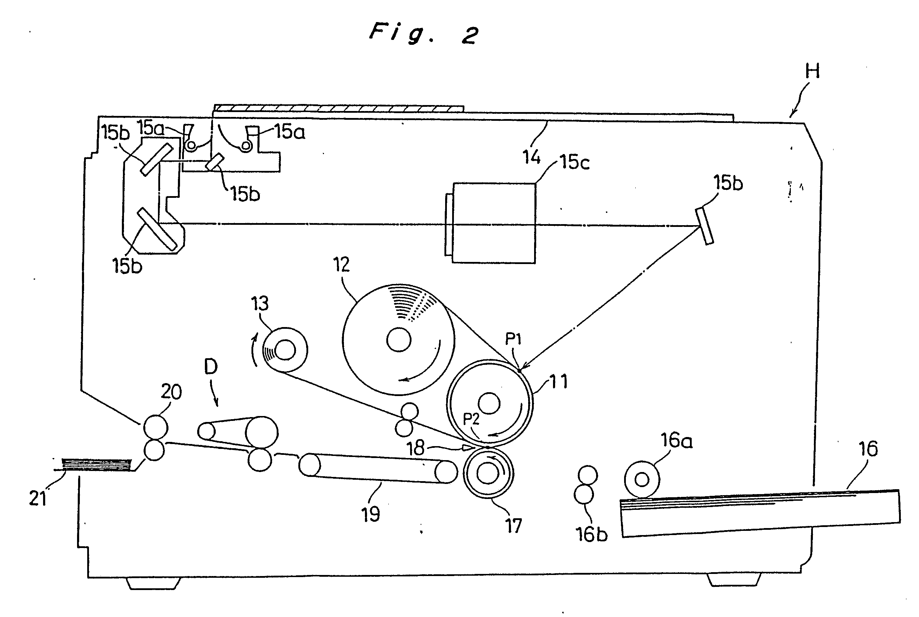

Referring first to Fig. 2, an image glazing device D of the present invention for producing a glossy image is accommodated in an image forming apparatus H in which the image is formed with the use of a photosensitive material and an image receiving material. The image forming apparatus of Fig. 2 is a copying apparatus.

The copying apparatus H is internally provided with a main drum 11 substantially at a central portion thereof, a photosensitive sheet supply roller 12 for supplying an unused photosensitive sheet therefrom, and a photosensitive sheet take-up roller 13 for taking up a used photosensitive sheet therearound. The supply and take-up rollers 12 and 13 are located leftwards of the main drum 11 as viewed in Fig. 2. The photosensitive sheet wound around the supply roller 12 is taken up by the take-up roller 13 by way of the main drum 11. In this event, one surface of the photosensitive sheet on which a large number of microcapsules are coated is directed outwards.

On an upper surface of the apparatus body is disposed a document platform 14, below which is disposed an optical system comprised of a plurality of light sources 15a, a plurality of mirrors 15b, a lens assembly 15c and the like. An original document placed on the document platform 14 is scanned by the

4

optical system so that light reflected from the original document may be led to an exposure point P1 on the main drum 11. As a result, the microcapsules of the photosensitive sheet engaging with the main drum 11 partly harden to form a selectively hardened image.

In a right-hand side portion of the apparatus body is detachably mounted a paper supply cassette 16 having thereon one or a plurality of image receiving sheets. A paper supply roller 16a for supplying the image receiving sheets one at a time is disposed above the paper supply cassette 16. Each image receiving sheet supplied from the paper supply cassette 16 once stops when it has been brought into contact with a pair of rollers 16b disposed leftwards of the paper supply roller 16a. Below the main drum 11 is positioned a pressure roller 17, which is biased against the main drum 11 by virtue of a biasing mechanism (not shown). Hereupon, a point at which the main drum 11 and the pressure roller 17 are in contact with each other is referred to as a pressure point P2. One surface of the photosensitive sheet on which the microcapsules are coated and one surface of the image receiving sheet to which developing material is caused to adhere are mated and subjected to pressure at the pressure point P2. The image receiving sheet which has once stopped at the paired rollers 16b is supplied to the pressure point P2 so that the leading end of the selectively hardened image formed on the photosensitive sheet may be coincident with the leading end of the image receiving sheet. At the pressure point P2, unhardened microcapsules of the photosensitive sheet are crushed so that colorless dye contained therein may flow out therefrom to effect coloring reaction by the action of the developing material of the image receiving sheet.

A separating claw piece 18 is disposed in the vicinity of the pressure point P2 to separate the image receiving sheet from the photosensitive sheet. The image receiving sheet separated from the photosensitive sheet is then transported towards the image glazing device D of the present invention by means of a transport belt 19 adjacent to the pressure roller 17. The image glazing device D is positioned substantially below the take-up roller 13 at a left-hand side portion inside the apparatus body, as viewed in Fig. 2. The image formed on the image receiving sheet is turned into a highly glossy image by the image glazing device D and is discharged onto a paper discharge tray 21 by means of a pair of paper discharge rollers 20. Accordingly, the paper discharge rollers 20 and the paper discharge tray 21 are located downstream of the image glazing device D in a direction of feed of the image receiving sheet.

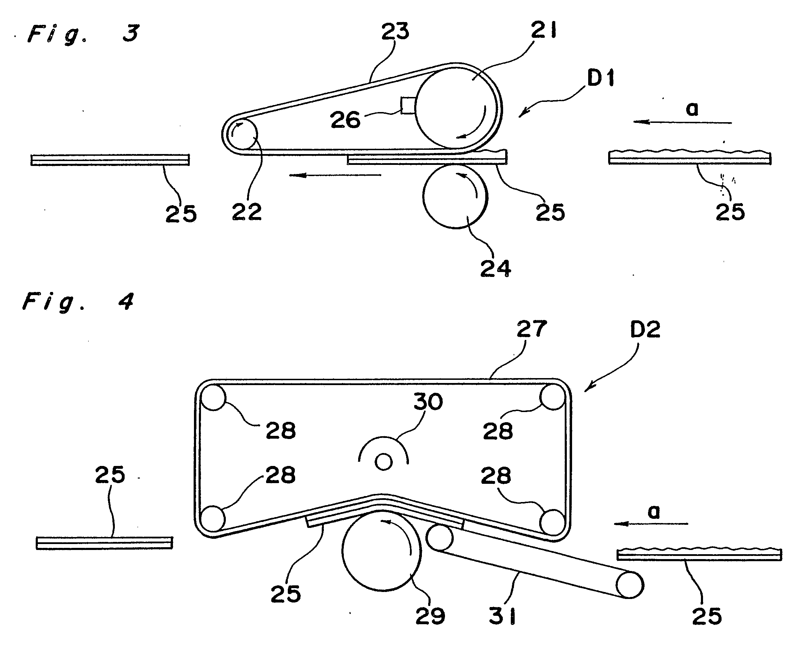

Referring next to Fig. 3, a method of producing a glossy image and a device for effecting this method will be hereinafter discussed according to the present invention. The image glazing device D1 for producing the glossy image according to the first embodiment of the present invention is comprised of a heat roller 21, a roller 22 spaced from the heat roller 21, an endless image glazing sheet 23 passed between the rollers 21 and 22 and a back-up roller 24 biased against the heat roller 21. The image glazing sheet 23 is a sheet required for producing the glossy image and rotates in the clockwise direction as viewed in Fig. 3 upon rotation of the heat roller 21 and the roller 22. The roller 22 has a diameter smaller than the heat roller 21 has. The image receiving sheet transported by the image glazing sheet 23 is separated therefrom at a location where the roller 22 is provided. Accordingly, the roller 22 constitutes a separating portion for separating the image receiving sheet from the image glazing sheet.

The heat roller 21 is provided inside it with a heat source comprised of, for example, a halogen lamp or lamps (not shown) and on its surface with a temperature sensor 26. The surface temperature of the heat roller 21 is detected by the temperature sensor 26 and controlled by a control portion (not shown). The temperature of the image glazing sheet 23 is raised up to substantially the same temperature of the heat roller 21, for example, up to a temperature between 120 and 130 $^{\circ}$C when passing it. The image glazing sheet 23 is then gradually cooled down as it travels away from the heat roller 21 upon rotation thereof.

Temperature distribution of the image glazing sheet 23 is properly determined in accordance with the melting point of thermoplastic resin coated on an image receiving sheet 25 and a traveling speed of the image glazing sheet 23. It is desirable to render the temperature of the image glazing sheet 23, when passing the roller 22, to be at least 20 $^{\circ}$C lower than the temperature thereof when passing the heat roller 21. If the temperature difference is less than 20 $^{\circ}$C, the offset is liable to take place. Preferably, the temperature of the image glazing sheet 23 at the roller 22 is less than 80 $^{\circ}$C. Furthermore, it is desirable to render the traveling speed of the image glazing sheet 23 to be less than 50 mm/sec.

A material having a smooth surface and superior resistance to heat more than 120 $^{\circ}$C is desirably employed as the image glazing sheet 23 used for producing the glossy image. It is also desirable that the material to be employed as the image receiving sheet 23 is superior in mold-releasing characteristic, flexibility and durability. As the material having the above described properties. are employed, for example, polyester, fluorine resin, silicone resin, polyamide resin, polyacetal, polycarbonate, fabric-filled phenol resin, glass fiber-filled nylon, glass fiber-filled polyacetal, glass fiber-filled polycarbonate, polyimide, polyphenylene oxide, filled fluorine resin, polyamide-imide, polyarylate, polyethyl ether ketone, polysulfone resin, polyphenylene sulfide resin, polybutylene terephthalate resin, polypropylene or the like. A desired thickness of the image glazing sheet 23 is approximately between 0.02 and 5 mm.

A metallic belt can be used as the image glazing sheet 23. In this case, the traveling speed of the image glazing sheet 23 may be increased but is required to be less than approximately 100 mm/sec. If the image glazing sheet 23 travels faster than this value, the offset is liable to take place, since the image receiving sheet 25 is hard to be separated from the image glazing sheet 23. The metallic belt is of nickel, nickel alloy, stainless steel, aluminium, aluminium alloy or the like. Although the thickness of the metallic belt is required to be changed according to the material thereof, the metallic belt having a thickness between 10 and 100 $\mu$m is desirably employed in view of flexibility and durability. The metallic belt is superior in resistance to heat and is advantageous in that the smooth surface can be readily obtained.

As described above, since the image glazing sheet has superior resistance to heat, it never be subjected to any warping caused by heat from a heating source, thereby preventing the image to be in disorder.

In the device of Fig. 3, the image receiving sheet 25 coated on its surface with thermoplastic resin or toner containing the thermoplastic resin is initially supplied between the heat roller 21 and the back-up roller 24 in a direction shown by an arrow (a) so that the coated surface of the image receiving sheet 25 may confront the image glazing sheet 23. The image receiving sheet 25 is subjected to pressure by the back-up roller 24 while being heated by the heat roller 21 and the image glazing sheet 23. Accordingly, the thermoplastic resin is softened or fused so that the smooth surface of the image glazing sheet 23 can satisfactorily smooth the thermoplastic resin. Since the image receiving sheet 25 is then transported along the image glazing sheet 23 and gradually cooled down, it is separated from the image glazing sheet 23 to be transported leftwards in Fig. 3. If the temperature of the image glazing sheet 23, when passing the roller 22, is at least 20 °C lower than that at the time when passing the heat roller 21, the image receiving sheet 25 is readily separated from the image glazing sheet 23 without being subjected to any offset. A separating mechanism including a separating claw piece and the like may be provided in the vicinity of the roller 22 to readily execute the separation between the image receiving sheet 25 and the image glazing sheet 23.

Several experiments were conducted with the use of the above described image glazing device D1.

Experiment 1

Experimental conditions were as follows:
(1) Image glazing sheet; polyester, 0.1 mm thick
(2) Surface temperature of heat roller; 120 °C
(3) Traveling speed of specimen; 20 mm/sec
(4) Load of roller; 40 kg/cm$^2$
(5) Specimen; a paper sheet having thereon a coated layer of the thermoplastic resin on which colorless dye was formed into a colored image.

For comparison with this experiment, another experiment was conducted with the use of the conventional oven type heating device shown in Fig. 1a. Experimental conditions were as follows:
(1) Ambient temperature; 150 °C
(2) Traveling speed of specimen; 5 mm/sec
(3) Specimen; a paper sheet having thereon a coated layer of the thermoplastic resin on which colorless dye was formed into a colored image, as in the foregoing experiment.

In the image glazing device D1 of Fig. 3, a high-quality image could be obtained without any offset. On the contrary, in the conventional heating device of Fig. 1a, heating caused the paper sheet to be curled and the trailing edge thereof to be warped up. The trailing edge of the paper sheet was occasionally scorched or burnt by any of the halogen lamps 4. 75° angle mirror surface glossiness was measured on a certain gloss meter with respect to the formed image on the basis of JIS (Japanese Industrial Standard) Z-8741. The glossiness of the image formed by the image glazing device D1 of Fig. 3 of the present invention was more than 90 whereas that of the image formed by the conventional heating device of Fig. 1a was between 70 and 80. It can be clearly understood that the image glazing device D1 of the present invention could form a highly glossy image.

Experiment 2

In this experiment, was fixed a paper sheet having thereon a colored image to which colored toner was transferred. Experimental conditions were as follows:

(1) Image glazing sheet; polyester, 0.1 mm thick
(2) Surface temperature of heat roller; 150 °C
(3) Traveling speed of specimen; 100 mm/sec
(4) Load of roller; 30 kg/cm$^2$
(5) Specimen; a paper sheet to which three kinds of colored toners, yellow, magenta and cyan, were transferred.

The experimental conditions of (2) to (4) correspond to those of the heat roller 7 used in the conventional device of Fig. 1b. Consequently, the offset caused by the toner adhering the heat roller 7 took place in the conventional device whereas a high gloss and high grade image could be obtained without any occurrence of the offset in the device D1 of the present invention.

In the above experiments, since the image glazing sheet 23 is of an endless belt, not only the peripheral length thereof can be shortened, for example, to 200 mm, but a control portion for controlling the joint position of the image glazing belt may not be provided in the device D1. If the belt has a joint, the joint is occasionally positioned on the image to be formed. In such a case, the joint can not smooth the image and lowers the image quality. To avoid this, the peripheral length of the belt is required to be longer than the maximum length of the image, which is, for example, 420 mm in a copying apparatus capable of copying the length up to A3-size. Accordingly, the jointed image glazing sheet renders the apparatus to become undesirably large. Furthermore, the position of the joint is required to be controlled so as not to position on the image to be formed.

In contrast, the image glazing sheet of an endless belt can shorten the peripheral length thereof and never requires the control portion for controlling the position of the joint. With the use of the endless image glazing belt having a peripheral length of 200 mm, a satisfactorily high quality image can be produced by an image forming apparatus capable of producing the image up to A-3 size.

Fig. 4 depicts the image glazing device D2 according to the second embodiment of the present invention. The image glazing device D2 is comprised of, a plurality of, for example four, rollers 28 having the same diameter, an image glazing sheet 27 in the form of an endless belt passed around these rollers 28 for putting a gloss to an image to be formed, a tension roller 29 located between two rollers 28 for applying tension to the image glazing sheet 27, and a heater 30 such as a halogen lamp, located on the opposite side of the tension roller 29 with respect to the image glazing sheet 27, for heating the image glazing sheet 27. In this device D2, an image receiving sheet 25 is initially correctly supplied between the image glazing sheet 27 and the tension roller 29 by means of a transport endless belt 31 so as to be subjected to both heat and pressure. The image receiving sheet 25 is then transported along the image glazing sheet 27 and finally separated therefrom while being cooled satisfactorily. A highly glossy image can be obtained by the device D2 having the above described construction.

The highly glossy image can also be obtained by controlling the temperature of the image receiving sheet using the conventional heating device 1 shown in Fig. 1a.

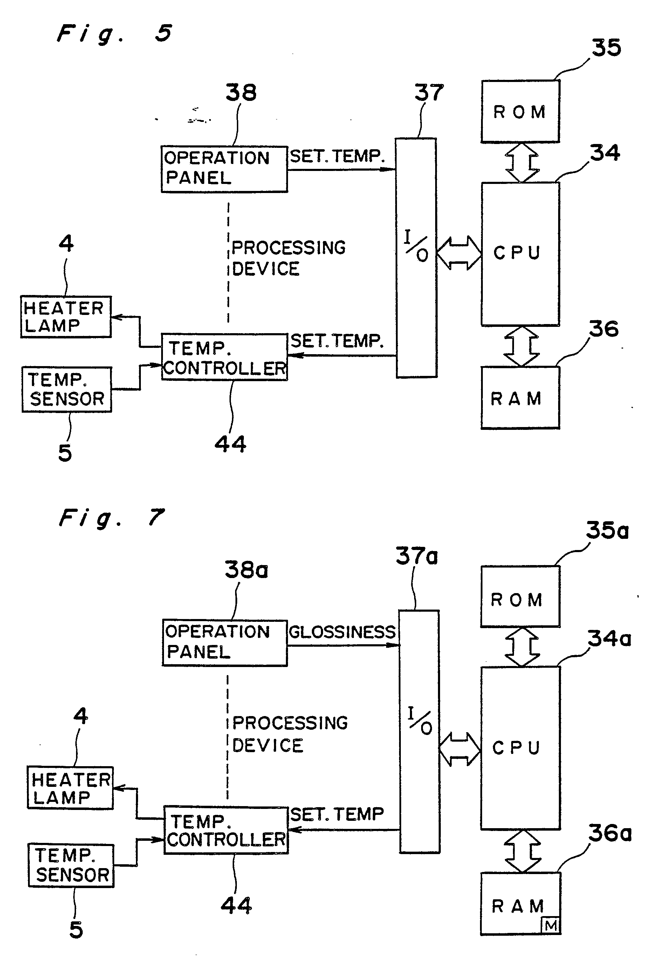

Fig. 5 is a block diagram required for controlling the temperature of the image receiving sheet.

The entire control is executed by a CPU 34 and a processing program thereof is stored in advance in a ROM 35. A RAM 36 is used as a working area when the processing program is being executed. A setting temperature of the heating device is inputted through an operation panel 38 provided on an upper surface of the main body of an image forming apparatus accommodating the device 1 of Fig. 1a. The setting temperature is inputted with the use of a volume dial, a changeover switch, ten-keys or the like. Input data from the operation panel 38 is inputted into the CPU 34 through an input/output interface 37. The heater lamps 4 and the temperature sensor 5 are connected to a temperature controller 44 of the heating device 1 which is further connected to the CPU 34 through the interface 37.

When the temperature of the heating device 1 is inputted by the operation panel 38 in accordance with the purpose of image formation, the setting temperature is outputted to the temperature controller 44. In this event, the temperature controller 44 controls the temperature in accordance with the output from the temperature sensor 5 by regulating electric current flowing in the heater lamps 4. The thermoplastic resin of the image receiving sheet 3 is properly softened or fused and covers the surface of a colored image to turn it into a glossy image.

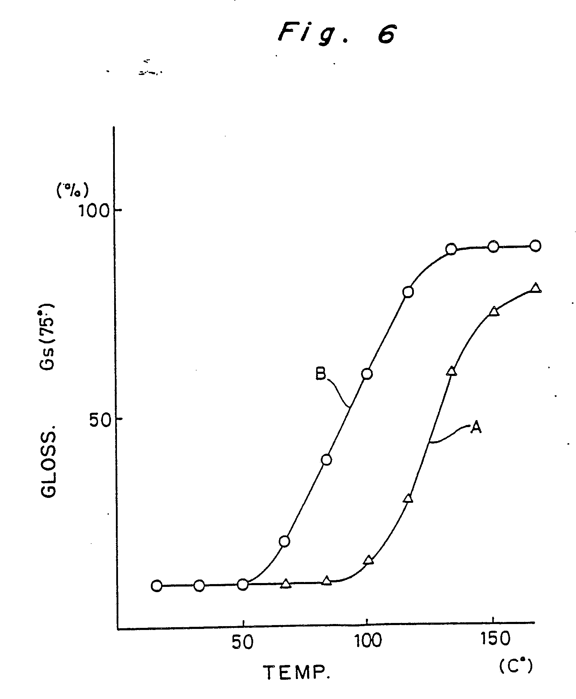

Fig. 6 is a graph showing the relationship between the setting temperature of the heating device 1 and the glossiness.

The traveling speed of the image receiving sheet 3 transported by the transport belt 2 was set to 10

7

mm/sec and the setting temperature was changed stepwise when the image was being formed. A reference character A in Fig. 6 represents the results of glossiness measurement conducted with respect to the formed image on the basis of 75° angle mirror surface glossiness prescribed in JIS Z-8741. It is to be noted as a guide that the glossiness of a photograph is approximately 100 % and that of a high quality printed color image is between 60 and 80 %. By this method, although an extremely high glossiness as well as that of the photograph could not be obtained, a high quality color image can be produced by setting the temperature in the range of 130 to 170 °C, since the glossiness between 60 and 80 % can be regarded sufficiently high in quality for the printed color image. The glossiness of an image in business graphics or the like may be less than that of the printed color image, and therefore, the setting temperature may be set below 130 °C.

Although the setting temperature of the heating device 1 is directly inputted for the heating process at this temperature in the above described embodiment, the glossiness may be inputted in place of the setting temperature.

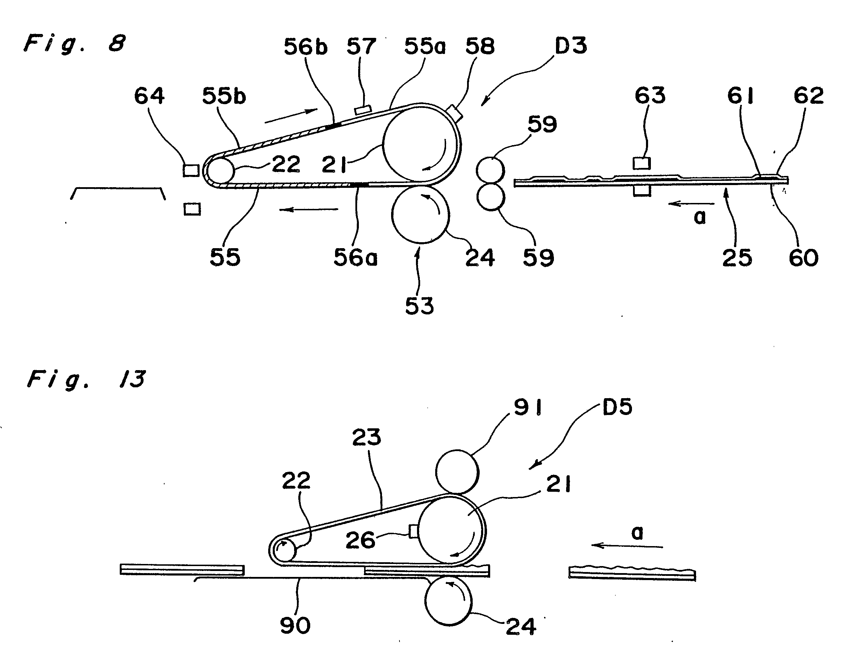

Fig. 7 is a block diagram of a control portion of the heating device 1 in which a desired temperature is set by inputting glossiness.

In the block diagram of Fig. 7, the glossiness is inputted from the operation panel 38a into the CPU 34a through the interface 37a. The relationship between the glossiness and the setting temperature shown by the reference character A in the graph of Fig. 6 is stored in advance in a memory M of the RAM 36a. A processing program for calculating the setting temperature from the inputted glossiness is stored in the ROM 35a.

When a desired glossiness is inputted from the operation panel 38a, the CPU 34a calculates the corresponding setting temperature on the basis of the inputted glossiness and outputs it to the temperature controller 44. Electric current to be supplied to the heater lamps 4 is then regulated in accordance with the setting temperature and an output from the temperature sensor 5. In this way, the glossiness of the colored image formed on the image receiving sheet 3 can be regulated.

The setting temperature may be changed by inputting the kind of an image to be formed.

Likewise, in the image glazing device D1 of Fig. 3, the surface temperature of the heat roller 21 is controllable by virtue of the temperature controller 44. The setting temperature may be also directly inputted from the operation panel or calculated by the CPU.

A reference character B shown in the graph of Fig. 6 represents the results of glossiness measurement obtained by changing the setting temperature with the use of the image glazing device D1 of Fig. 3. Since the colored image is smoothed in this device D1, a temperature range required for obtaining a highly glossy image is lower than that in the conventional heating device shown in Fig. 1a. The reference character B in Fig. 6 teaches that the maximum glossiness is 90 %, which is satisfactorily high.

A high glossiness for presenting an appearance of high quality or high grade is desirable with respect to a photograph, an illustration or the like whereas any high glossiness is not generally required with respect to characters, business graphics, a cloth or the like. Thus, the high glossiness is not always desired. Any desired glossiness can be obtained by the temperature control as described above using the same device, preferably the device of the present invention.

Accordingly, the setting temperature can be lowered when a certain image which does not require any high gloss is formed. This is advantageous in that electric power required for heating can be saved, thus resulting in a lowered running cost of the device.

Fig. 8 depicts the image glazing device D3 according to the third embodiment of the present invention, which is capable of rapidly switching the gloss to be applied to an image formed.

An image forming apparatus accommodating the image glazing device D3 of Fig. 8 also executes the imaging process as disclosed in the Japanese Patent Laid-Open Application No. 58-88739 described hereinabove.

In Fig. 8, the image receiving sheet 25 supplied from the supply cassette 16, together with the photosensitive sheet having thereon a selectively hardened image, is subjected to pressure. In this event, the selectively hardened image is transferred onto the image receiving sheet 25. When the image receiving sheet 25 is supplied from the supply cassette 16, it is in a state in which developing material is entirely overcoated with a thermoplastic resin layer. However, when the image receiving sheet 25 has passed through the pressure point P2, it is brought into a state in which the transferred image is overcoated with the thermoplastic resin layer, since the developing material displays its coloring effect. In Fig. 8, reference numerals 60, 61 and 62 designate a support member of a paper sheet or the like, the transferred image and the thermoplastic resin, respectively. The leading end of the image receiving sheet 25 is detected by a sensor 63 located upstream of the image glazing device D3 in a direction of feed of the image receiving sheet 25. When the sensor 63 has detected the leading end of the image receiving sheet 25, the image

8

glazing device D3 is brought into operation. The arrangement of an image glazing sheet 55, a heat roller 21, a roller 22 and a back-up roller 24 are the same as that in the image glazing device D1 shown in Fig. 3. In this embodiment, however, the image glazing sheet 55 consists of two kinds of sheets 55a and 55b, which are different from each other in surface smoothness. Two leading end detecting marks 56a and 56b are printed on two joints between the first and second glazing sheet 55a and 55b, respectively. The first leading end detecting mark 56a is located on the leading end of the first glazing sheet 55a and the second leading end detecting mark 56b is located on the leading end of the second glazing sheet 55b. In the vicinity of the heat roller 21 is disposed a sensor 57 for detecting the leading end detecting marks 56a and 56b. The position of the sensor 57 is determined so that the length from the nipping area between the heat roller 21 and the back-up roller 24 up to the sensor 57 along the image glazing sheet 55 may be equal to the length between the sensor 63 for detecting the leading end of the image receiving sheet 25 and the nipping area. The surface temperature of the heat roller 21 is controlled by virtue of a temperature sensor 58 confronting the heat roller 21. A pair of timing rollers 59 are located upstream of the heat roller 21 and the back-up roller 24 in a direction of feed of the image receiving sheet 25 so that the image receiving sheet 25 may be supplied to the image glazing device D3 after it has passed through the paired timing rollers 59. Downstream of the roller 22 is positioned a sensor 64 for detecting the trailing end of the image receiving sheet 25.

In the case where the image receiving sheet 25 is brought into contact with and transported by the first image glazing sheet 55a, a control portion once stops the operation of the image glazing sheet 55 when the sensor 57 has detected the first leading end detecting mark 56a. Thereafter, when the sensor 63 has detected the leading end of the image receiving sheet 25, the control portion resumes the operation of the image glazing sheet 55. On the other hand, in the case where the image receiving sheet 25 is brought into contact with and transported by the second image glazing sheet 55b, the control portion once stops the operation of the image glazing sheet 55 when the sensor 57 has detected the second leading end detecting mark 56b. Thereafter, when the sensor 63 has detected the leading end of the image receiving sheet 25, the control portion resumes the operation of the image glazing sheet 55. This control will be discussed hereinafter. The surface smoothness of the second image glazing sheet 55b is rendered very high in this embodiment. The first image glazing sheet 55a is rendered lower in surface smoothness than the second image glazing sheet 55b. If an operator has selected low glossiness, the sensor 57 detects the first leading end detecting mark 56a so that the image receiving sheet 25 may be transported by the first image glazing sheet 55a. In contrast, if the operator has selected high glossiness, the sensor 57 detects the second leading end detecting mark 56b so that the image receiving sheet 25 may be transported by the second image glazing sheet 55b.

The image receiving sheet 25 nipped between the heat roller 21 and the back-up roller 24 is heated by the heat roller 21, rendering the thermoplastic resin 62 coated on the image receiving sheet 25 to be fused. The image receiving sheet 25 is then transported as far as the roller 22 and gradually cooled down while being kept in contact with the image glazing sheet 55. On this occasion, if the image glazing sheet 55 transporting the image receiving sheet 25 is the second image glazing sheet 55b having high smoothness, the fused thermoplastic resin hardens in a smooth state. To the contrary, if the image receiving sheet 25 is transported by the first image glazing sheet 55a having lower smoothness, the fused thermoplastic resin hardens in a state in which its surface is uneven. Because of this, a high gloss image is obtained in the case of the former whereas a relatively low gloss image is obtained in the case of the latter.

An experiment was conducted in which gloss was applied to the image receiving sheet, using the device shown in Fig. 8.

Experiment 3

Experimental conditions were as follows.

|  | Surface Rough. | Material |
|---|---|---|
| Glazing sheet 55b | 0.03 μmPz | polyester, 0.1 mm thick |
| Glazing sheet 55a | 5 μmPz | polyester, 0.1 mm thick |
| Temp. of sheet: | 120 °C |  |
| Travel. speed of sheet: | 20 mm/sec |  |
| Load of roller: | 4 kg/cm$^2$ |  |

The results are shown below.

|  | Glossiness Gs(75°) |
|---|---|
| Glazing sheet 55b | 90 |
| Glazing sheet 55a | 20 |

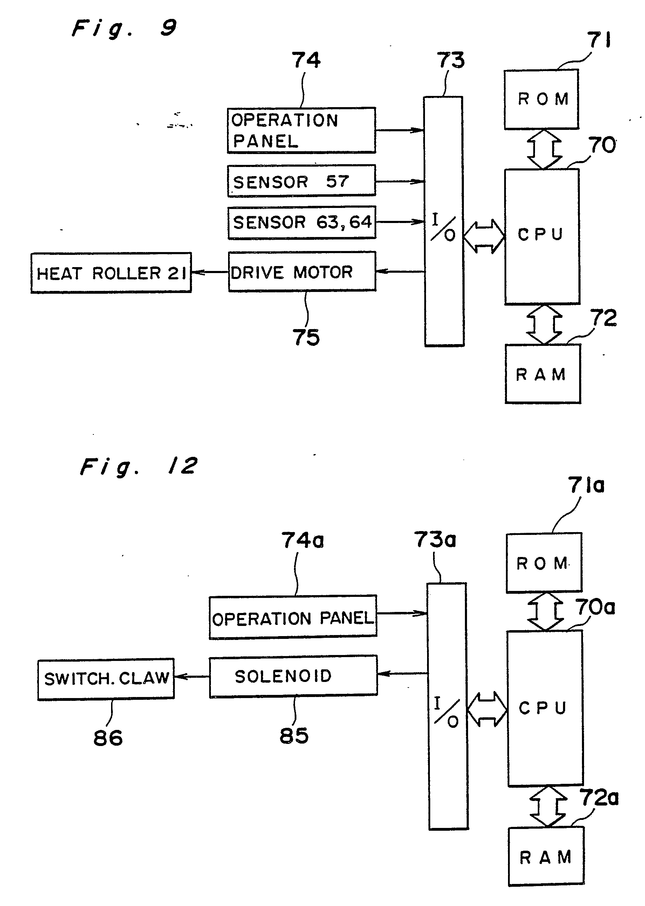

Fig. 9 is a block diagram of the control portion of the image forming apparatus accommodating the image glazing device D3 according to this embodiment.

A CPU 70 is coupled with a ROM 71 for storing therein a processing program, a RAM 72, to which a working area or the like is assigned, for storing therein, the traveling speed of the image glazing sheet 55, the control temperature of the heat roller 21 and the like, and an I/O interface 73. The I/O interface 73 is further coupled with an operation panel 74, the above described sensors 57, 63 and 64, and a drive motor 75 of the heat roller 21. Various kinds of other elements for controlling the entire image forming apparatus are also coupled with the CPU 70 but not shown in Fig. 9.

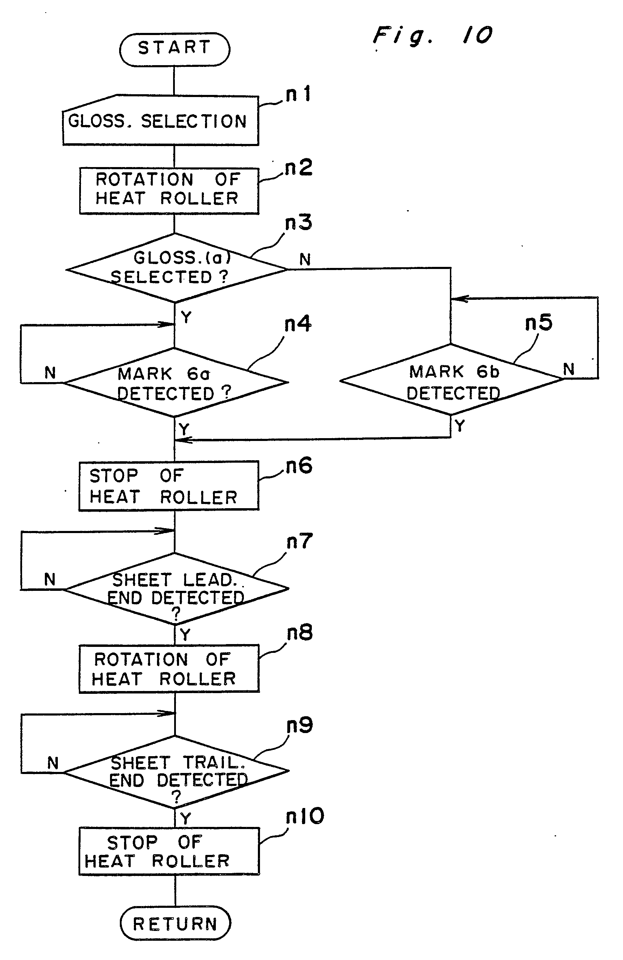

Fig. 10 depicts a flow-chart indicative of the control operation for the image glazing device D3.

The operator initially inputs a desired glossiness with the use of the operation panel 74 at step n1 followed by step n2 at which the heat roller 21 is heated and rotated for a predetermined period of time, thereby rotating and uniformly heating the image glazing sheet 55 up to a certain temperature. It is judged at step n3 whether either a glossiness (a) or another glossiness (b) has been selected. If the glossiness (a) has been selected at step n3, the procedure proceeds to step n4 at which it is judged whether or not the sensor 57 has detected the first leading end detecting mark 56a. If the glossiness (b) has been selected at step n3, the procedure proceeds to step n5 at which it is judged whether or not the sensor 57 has detected the second leading end detecting mark 56b. When the sensor 57 has detected the first leading end detecting mark 56a at step n4 or the second leading end detecting mark 56b at step n5, the image glazing sheet 55 is brought to a standstill at step n6 followed by step n7 at which it is judged whether or not the sensor 63 has detected the leading end of the image receiving sheet 25. When the sensor 63 has detected the leading end of the image receiving sheet 25 at step n7, the heat roller 21 resumes its rotation to drive the image glazing sheet 55 at step n8. In this way, the image receiving sheet 25 is brought into contact with desired one of the image glazing sheets 55a and 55b so that an image having the desired glossiness may be produced. When the sensor 64 has detected the trailing end of the image receiving sheet 25 at step n9, the heat roller 21 is again brought to a standstill to stop the operation of the image glazing sheet 55 at step n10. In the above described procedure, steps n3 to n6 signify a means for selecting the desired glossiness.

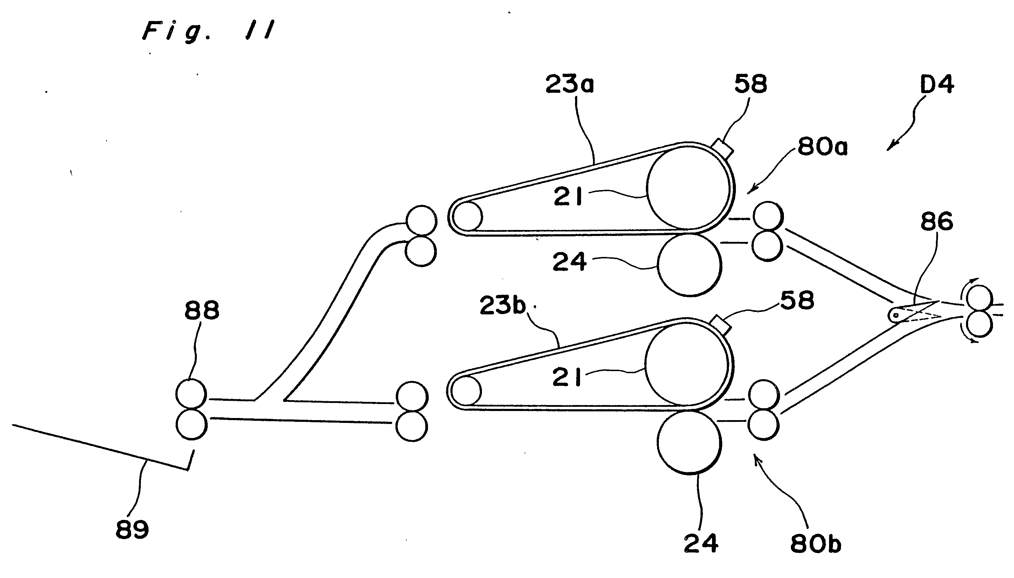

Fig. 11 depicts the image glazing device D4 according to the fourth embodiment of the present invention in which the image receiving sheet can be selectively introduced to either of two sets of image glazing portions 80a and 80b by means of a switching claw piece 86. The two image glazing portions 80a and 80b are independent of each other and provided with respective image glazing sheets 23a and 23b which are different in surface smoothness.

More specifically, the first image glazing portion 80a is provided with the image glazing sheet 23a having a relatively low surface smoothness whereas the second image glazing portion 80b is provided with the image glazing sheet 23b having a higher surface smoothness. The switching claw piece 86 is located upstream of the two image glazing portions 80a and 80b in a direction of feed of the image receiving sheet so that the image receiving sheet may be selectively introduced to either of the two image glazing portions 80a and 80b by the switching claw piece 86. When the switching claw piece 86 is set at a position shown by a solid line in Fig. 11, the image receiving sheet is introduced to the second image glazing portion 80b.

In contrast, when the switching claw piece 86 is set at another position shown by a chain line in Fig. 11, the image receiving sheet is introduced to the first image glazing portion 80a.

Fig. 12 is a block diagram of the control portion according to this embodiment. Since the glossiness can be changed by the switching claw piece 86, the CPU 70a controls a solenoid 90 for driving the switching claw piece 86 in compliance with an input from the operation panel 74a.

As shown in Fig. 8 or 11, when the image glazing device D3 or D4 is provided with a switching means for rapidly selecting either one of two image glazing sheets which are different in surface smoothness, the glossiness selection can be conducted relatively in a short time, as compared with the device in which the glossiness of the image is changed by controlling the setting temperature.

It is to be noted here that in the device D3 or D4, although either one of two kinds of gloss can be applied to the image to be formed, the kind of gloss can be readily increased. Furthermore, since the surface smoothness never varies in accordance with environmental conditions such as temperature or the like, the glossiness of the image to be obtained is fixed without being affected thereby.

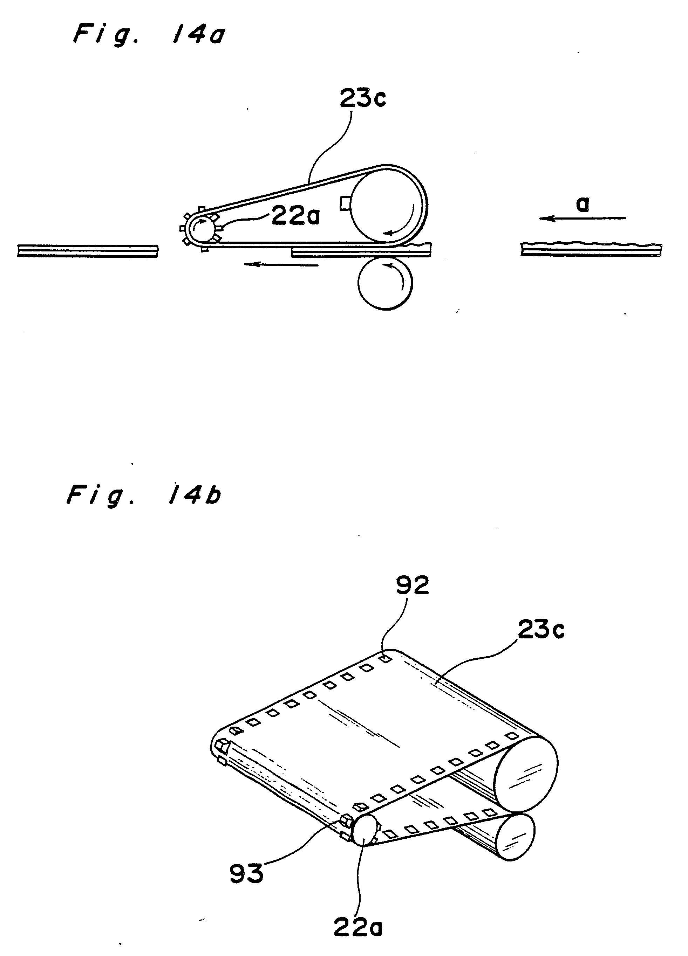

Fig. 13 is the image glazing device D5 according to the fifth embodiment of the present invention.

The image glazing device D5 according to this embodiment is provided with a paper transport guide 90 and a cleansing roller 91, in addition to the device D1 of Fig. 3. A paper transport guide 90 is located downstream of the back-up roller 24 in a direction of feed of the image receiving sheet 25 so that a paper transport portion may be constituted between the paper transport guide 90 and the image glazing sheet 23. If a cooling fan or the like is provided in this paper transport portion to cool the image receiving sheet 25 and the image glazing sheet 23, the cooling rate thereof can be raised. In this case, even if the distance between the heat roller 21 and the roller 22 is shortened to some extent, the cooling fan can effectively and sufficiently cool the image receiving sheet 25. The shortened distance between the heat roller 21 and the roller 22 can contribute to miniaturization of the image glazing device. The cleaning roller 91 is comprised of felt, sponge or the like and is in contact with the image glazing sheet 23 to remove the thermoplastic resin or the like adhering to the image glazing sheet 23. In the image glazing device D5 of the present invention, although the thermoplastic resin does not appreciably adhere to the image glazing sheet 23 to the extent of causing the offset, even a small quantity of the thermoplastic resin, dust or the like which may adhere to the image glazing sheet 23 can be removed by the cleaning roller 91. The cleaning roller 91 may be replaced by a cleaning blade which is brought into contact with the image glazing sheet 23, the combination of a rotatable fur brush and a vacuum pump or the like. Whichever cleaning means is employed, a simplified construction on a small scale is practically usable.

Several copying experiments were conducted using a copying apparatus accommodating the image glazing device D5 having the above described construction.

## Experiment 4

Experimental conditions were as follows:

(1) Glazing sheet; a smooth endless belt having a peripheral length of 200 mm and a thickness of 75 $\mu$m, and made of polyimide resin having a softening point of 700 $^\circ$C

(2) Temperature of glazing sheet at heat roller; 125 $^\circ$C

(3) Traveling speed of glazing sheet; 20 mm/sec

(4) Load of back-up roller; 4 kg/cm$^2$.

## Experiment 5

In this experiment, the cleaning roller 91 was not provided in the device D5.

Experimental conditions were as follows:

(1) Glazing sheet; a smooth endless belt of nickel having a peripheral length of 200 mm and a thickness of 40 $\mu$m

(2) Temperature of glazing sheet at heat roller; 125 $^\circ$C

(3) Traveling speed of glazing sheet; 20 mm/sec

(4) Load of back-up roller; 4 kg/cm$^2$.

In both experiments, fifty sheets of A4-sized original documents were successively copied. As a result, substantially the same highly glossy image could be formed on all of copied paper sheets. The 75 $^\circ$ angle mirror surface glossiness of the copied image was more than 90, which is sufficiently high.

For comparison with these experiments, another experiment was conducted with the use of a smooth endless belt of polyethylene having a thickness of 100 μm. It is well known that polyethylene is relatively inferior in resistance to heat. The reason why the belt of polyethylene is thicker than that of the material used in Experiments 4 and 5 is to raise the strength of the belt against crumpling. On condition that other experimental conditions such as the temperature of the image glazing sheet, the traveling speed thereof, the load of the back-up roller and the like were set to be the same as those of the above two experiments, fifty sheets of A-4 sized original documents were successively copied. In this experiment, notwithstanding the fact that the image glazing belt was thickened to 100 μm, the crumpling took place after ten sheets of documents had been copied. When all the documents had been copied, the gloss of the image was uneven due to the crumpling.

Although the above experiments were conducted with the use of an image forming apparatus employing therein the photosensitive sheet and the image receiving sheet, two further experiments were conducted with the use of a different kind of image forming apparatus provided with a photosensitive member, for example, a photosensitive drum, in which toner is transferred onto a transfer sheet to form a visible image. For example, a fully colored toner image was initially transferred onto the transfer sheet, using a copying apparatus employing therein the electrophotographic method. The transfer sheet was then fixed by the image glazing device D5 of Fig. 13, with the cleaning roller 91 removed.

Experiment 6

Experimental conditions were as follows:
(1)Glazing sheet; a smooth endless belt of polyimide having a peripheral length of 200 mm and a thickness of 75 μm
(2) Temperature of glazing sheet at heat roller; 150°C
(3) Traveling speed of glazing sheet; 50 mm/sec
(4) Load of back-up roller; 4 kg/cm².

Experiment 7

Experimental conditions were as follows:
(1) Glazing sheet; a smooth endless belt of nickel having a peripheral length of 200 mm and a thickness of 40 μm
(2) Temperature of glazing sheet at heat roller; 150°C
(3) Traveling speed of glazing sheet; 50 mm/sec
(4) Load of back-up roller; 4 kg/cm².
In these two experiments, substantially the same highly glossy image could be formed on all of fifty sheets of successively copied paper sheets.

As is clear from these experiments, the highly glossy image can be obtained with the use of the image glazing device of the present invention, even in the image forming apparatus employing therein the toner.

As shown in Figs. 14a and 14b, the roller 22a may be provided with a plurality of regularly spaced sprockets 93 on opposite ends thereof. In this case, it is necessary to form a plurality of regularly spaced openings 92 on opposite sides of the image glazing sheet 23c so that the sprockets 93 of the roller 22a may engage with these openings 92, thereby preventing a slip between the image glazing sheet 23c and the roller 22a.

From the foregoing, according to the method or the device of the present invention, the highly glossy image can be obtained upon application of heat and pressure to the image receiving sheet. The high gloss raises the image quality and presents an appearance of high grade. The image glazing device of the present invention is advantageous in that the device can be formed into a compact size, as compared with the conventional oven type indirect heating device, and the image receiving sheet can be prevented from being scorched or burnt. Furthermore, as compared with the conventional direct heating device employing therein the heat roller, the offset hardly takes place in the device of the present invention, thereby preventing the image being stained or spoiled. Accordingly, a cleaner for removing the thermoplastic resin adhering to the heat roller may not be provided in the device, thus resulting in that the device can be formed into a simplified construction at a reduced cost.

It is to be noted that the image glazing sheet in the form of a belt is employed in the above described embodiments, a flat sheet may be used as the image glazing sheet. In this case, the conventional heating device of Fig. 1b is serviceable for applying heat and pressure to the image receiving sheet 3. Even in such a construction, since the image glazing sheet is overlapped onto the image receiving sheet, any offset never takes place on the heat roller 7. Upon cooling the image receiving material together with the image glazing sheet, the former can be readily separated from the latter due to the superior mold-releasing characteristic of the latter. In this way, the highly glossy image can be also obtained.

It is also to be noted that in the above described embodiments, although the image glazing device D1, D3, D4 or D5 is provided with the heat roller 21 accommodating a heating source, the heating source may be provided in the vicinity of the back-up roller 24.

Although the present invention has been fully described by way of examples with reference to the accompanying drawings, it is to be noted here that various changes and modifications will be apparent to those skilled in the art. Therefore, unless such changes and modifications otherwise depart from the spirit and scope of the present invention, they should be construed as being included therein.

## Claims

1. A method of producing a glossy image, comprising the steps of:
mating an image glazing sheet for putting a gloss to an image to be formed with an image receiving material on which the image is formed by toner containing thermoplastic resin or which is coated with the thermoplastic resin, said image glazing sheet having a smooth surface and being superior in resistance to heat and mold-releasing characteristic;
applying heat and pressure to said image receiving material and said image glazing sheet;
cooling said image receiving material and said image glazing sheet: and
separating said image receiving material from said image glazing sheet.

2. An image glazing device, for use in an image forming apparatus, for putting a gloss to an image formed on an image receiving material, said image being formed by toner containing thermoplastic resin or coated with the thermoplastic resin, said device comprising:
at least two rollers disposed in a direction of feed of said image receiving material;
an image glazing sheet passed between said two rollers for putting the gloss to the image formed on said image receiving material;
a back-up roller disposed upstream of one ofsaid two rollers in a direction of feed of said image receiving material for applying pressure to said image receiving material; and
a heat source disposed in the vicinity of said back-up roller for heating said image receiving material,
whereby said image receiving material is overlapped onto said image glazing sheet and subjected to both heat and pressure so that the gloss may be applied to the image formed on said image receiving material.

3. The device according to Claim 2, further comprising means for variably setting temperature up to which said image receiving material is heated so that glossiness of the image formed thereon may be regulated.

4. The device according to Claim 2, comprising a plurality of image glazing sheets different in surface smoothness and a switching means for causing said image receiving material to be in contact with any one of said image glazing sheets.

5. The device according to claim 2, wherein said image glazing sheet has a smooth surface and resistance to heat more than 120 $^\circ$C.

6. The device according to claim 2, further comprising a paper transport guide means disposed, along an outer periphery of said image glazing sheet, downstream of said back-up roller in a direction of feed of said image receiving material.

7. The device according to claim 2, wherein said image glazing sheet is a metallic belt.

Fig. 1a    PRIOR ART

Fig. 1b    PRIOR ART

EP 0 301 585 A2

Case: 619231 Sh - Mü

SHARP KABUSHIKI KAISHA

SHARP KABUSHIKI KAISHA

Case: 619231 Sh - Mü

Fig. 2

Fig. 3

Fig. 4

EP 0 301 585 A2

SHARP KABUSHIKI KAISHA
Case: 619231 Sh - Mü

Fig. 5

Fig. 7

# Fig. 6

Fig. 8

56b 57 55a 58 D3

64 55b 63 61 62

59

22 21

55 56a 24 59 25 60

53

a

Fig. 13

91 D5

23

22 21

26

90 24

a

EP 0 301 585 A2

Case: 619231 Sh - Mü

SHARP KABUSHIKI KAISHA

SHARP KABUSHIKI KAISHA

Case: 619231 Sh - Mü

Fig. 9

74 OPERATION PANEL

73

71 ROM

70

SENSOR 57

SENSOR 63,64

I/O

CPU

HEAT ROLLER 21 ← DRIVE MOTOR

75

72 RAM

Fig. 12

74a OPERATION PANEL

73a

71a ROM

70a

SWITCH. CLAW ← SOLENOID

I/O

CPU

86

85

72a RAM

*Fig. 10*

```
         ┌─────────────┐
         │    START    │
         └──────┬──────┘
                │
       ┌────────┴────────┐  ─n1
       │ GLOSS. SELECTION│
       └────────┬────────┘
                │
       ┌────────┴────────┐  n2
       │  ROTATION   OF  │
       │  HEAT ROLLER    │
       └────────┬────────┘
                │          n3
              ╱─┴─╲
            ╱ GLOSS.(a) ╲─── N ──────────────────┐
            ╲ SELECTED ? ╱                        │
              ╲─┬─╱                               │
                │ Y                               │
    ┌──────────►│            n4          n5       ▼ ◄──────┐
    │         ╱─┴─╲                    ╱─────╲             │
    └── N ──╱  MARK 6a ╲       ╱ MARK 6b ╲── N ───────────┘
           ╲ DETECTED ? ╱       ╲ DETECTED ╱
             ╲─┬─╱               ╲──┬──╱
               │ Y                  │ Y
               │◄───────────────────┘
       ┌───────┴───────┐  n6
       │  STOP    OF   │
       │  HEAT  ROLLER │
       └───────┬───────┘
    ┌─────────►│          n7
    │        ╱─┴─╲
    └── N ──╱ SHEET LEAD. ╲
           ╲ END DETECTED ╱
             ╲  ? ┬ ╱
                  │ Y
       ┌──────────┴──────┐  n8
       │  ROTATION   OF  │
       │  HEAT  ROLLER   │
       └────────┬────────┘
    ┌──────────►│          n9
    │         ╱─┴─╲
    └── N ──╱ SHEET TRAIL. ╲
           ╲ END DETECTED  ╱
             ╲   ? ┬ ╱
                   │ Y
       ┌───────────┴─────┐  n10
       │  STOP    OF     │
       │  HEAT  ROLLER   │
       └────────┬────────┘
                │
         ┌──────┴──────┐
         │   RETURN    │
         └─────────────┘
```

Fig. 11

EP 0 301 585 A2

SHARP KABUSHIKI KAISHA
Case: 619231 Sh - Mü

SHARP KABUSHIKI KAISHA

Case: 619231 Sh - Mü

Fig. 14a

Fig. 14b